# EUROPEAN PATENT SPECIFICATION

(11) **EP 2 095 188 B1**
(45) Date of publication and mention of the grant of the patent: **22.02.2017**
(21) Application number: 07834200.3
(22) Date of filing: 21.11.2007
(51) Int. Cl.: G03F 7/004

(54) **HARDMASK COMPOSITION FOR PROCESSING RESIST UNDERLAYER FILM, PROCESS FOR PRODUCING SEMICONDUCTOR INTEGRATED CIRCUIT DEVICE USING THE HARDMASK COMPOSITION, AND SEMICONDUCTOR INTEGRATED CIRCUIT DEVICE PRODUCED BY THE PROCESS**
HARTMASKENZUSAMMENSETZUNG ZUM VERARBEITEN EINES RESISTUNTERSCHICHTFILMS, PROZESS ZUR HERSTELLUNG EINES INTEGRIERTEN HALBLEITERBAUELEMENTS UNTER VERWENDUNG DER HARTMASKENZUSAMMENSETZUNG UND DURCH DEN PROZESS HERGESTELLTES INTEGRIERTES HALBLEITERSCHALTUNGSBAUELEMENT
COMPOSITION DE MASQUE DUR SERVANT À TRAITER UN FILM DE SOUS-COUCHE DE RÉSERVE, PROCÉDÉ SERVANT À PRODUIRE UN DISPOSITIF DE CIRCUIT INTÉGRÉ À SEMI-CONDUCTEUR UTILISANT LA COMPOSITION DE MASQUE DUR ET DISPOSITIF DE CIRCUIT INTEGRE À SEMI-CONDUCTEUR PRODUIT PAR LE PROCEDE

(30) Priority: 21.11.2006 KR 20060115411
(43) Date of publication of application: 02.09.2009
(73) Proprietor: CHEIL INDUSTRIES INC., Gumi-si, Gyeongsangbuk-do 730-710 (KR)
(72) Inventor: KIM, Mi Young, Suwon 442-192 (KR); KIM, Sang Kyun, Yongin 448-150 (KR); LIM, Sang Hak, Incheon 407-330 (KR); KOH, Sang Ran, Gunpo 435-040 (KR); YUN, Hui Chan, Ulsan 681-340 (KR); KIM, Do Hyeon, Gunpo 435-030 (KR); UH, Dong Seon, Seoul 138-227 (KR); KIM, Jong Seob, Daejeon 305-390 (KR)
(74) Representative: Lang, Johannes
(86) International application number: PCT/KR2007/005894
(87) International publication number: WO 2008/063016

(56) References cited:
- WO-A1-03/089992
- WO-A2-02/16477
- JP-A- 2007 291 167
- US-A1- 2004 247 900
- US-A1- 2005 031 791
- US-A1- 2005 042 538
- US-A1- 2005 112 383
- US-A1- 2005 277 058

## Description

### Technical Field

the present invention relates to a hardmask composition for processing a resist underlayer film and a process for producing a semiconductor integrated circuit device using the hardmask composition. More particularly, the present invention relates to a hardmask composition for processing a resist underlayer film that exhibits excellent film characteristics and good storage stability, allows transferring a good pattern to a material layer die to its satisfactory hardmask characteristics, and has improved etch resistance against O₂ plasma gas upon subsequent etching for patterning.

### Background Art

For better resolution in most lithographic processes, an antireflective coating (ARC) material is used to minimize the reflectivity between a resist material layer and a substrate. However, the similarity in basic composition between the ARC and the resist material layer results in poor etch selectivity between the ARC material and the patterned resist layer. Accordingly, portions of the resist layer is inevitably consumed during etching of the ARC after patterning, thus requiring further patterning of the resist layer in the subsequent etching step.

Resist materials used in some lithographic techniques do not provide satisfactory resistance to the subsequent etching step to an extent sufficient to effectively transfer a desired pattern to a layer underlying the resist material. A hardmask has been used to etch an underlying resist underlayer film, for example, in the case when an extremely thin resist material is used, a substrate to be etched is thick, a large etching depth is needed, and/or the use of a particular etchant is required depending on the type of substrate.

Patent document US 2005/042538 A1 discloses antireflective hardmask compositions and techniques for the use of antireflective hardmask compositions for processing of semiconductor devices. The antireflective hardmask layer comprises a carbosilane backbone comprising at least one chromophore moiety and at least one transparent moiety; and a crosslinking component.

### Disclosure of Invention

### Technical Problem

The hardmask plays a role as an intermediate layer between a patterned resist and a substrate to be patterned. The hardmask serves to transfer a pattern of the patterned resist to the substrate. Therefore, the hardmask must be able to withstand etching required for the transfer of the pattern.

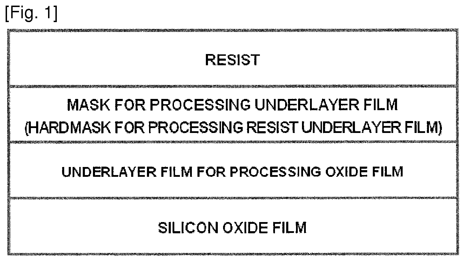

For example, a resist pattern is used as a mask to etch a substrate, e.g., a silicon oxide film. Miniaturization of circuits has resulted in a reduction of the thickness of resists, making it difficult for the resists to act as masks. As a result, etching of oxide films without any damage is substantially impossible. To overcome these problems, a resist pattern is transferred to an underlayer film for processing an oxide film, followed by dry etching the oxide film using the pattern-transferred underlayer film as a mask. The underlayer film for processing the oxide film refers to a film that is formed under an antireflective film to function as an underlayer antireflective film. In this process, since the etch rate of the resist is similar to that of the underlayer film, it is necessary to form a mask between the resist and the underlayer film to etch the underlayer film. Specifically, an underlayer film for processing an oxide film, a mask for processing the underlayer film (*i.e.* a hardmask for processing the resist underlayer film) and a resist are formed sequentially on an oxide film. This multilayer structure is shown in FIG. 1.

It is generally known that a structurally stable hardmask having a high silicon content exhibits improved etch resistance to an etching gas composed essentially of oxygen. A polycondensation product of silane compounds represented by R ₐSi(OR)₄₋ₐ, to which H ₐSi(OR)₄₋ₐ is added, is inevitably used to form a hardmask having an increased silicon content.

However, typical silane compounds containing hydrogen are sufficiently reactive to undergo uncontrollable condensation reactions even in the presence of a small amount of water without the use of an additional catalyst during hydrolysis. In addition, the highly reactive silane compounds tend to be gelled during condensation or purification. These disadvantages make it difficult to synthesize a polymer having required physical properties using the silane compounds. Due to unsatisfactory stability of the polymer, it is difficult to prepare a solution of the polymer that is stable during storage. Under these circumstances, further improvements are required to stabilize polymers having a high silicon content.

### Technical Solution

The present invention has been made in an effort to solve the problems of the prior art, and it is one object of the present invention to provide a hardmask composition for processing a resist underlayer film that exhibits excellent film characteristics and good storage stability and allows transferring a good pattern to a material layer due to its satisfactory hardmask characteristics.

It is a more particular object of the present invention to provide a hardmask composition for processing a resist underlayer film that has improved etch resistance against O₂ plasma gas upon subsequent etching for patterning.

It is one of other objects of the present invention to provide a process for producing a semiconductor integrated circuit device using the hardmask composition.

It is one of other objects of the present invention to provide a device produced by the process.

In order to accomplish the above objects of the present invention, disilane monomer units were used in the base resin of the hardmask composition.

Specifically, the hardmask composition of the present invention comprises an organosilane polymer according to claim 1 and a solvent wherein the organosilane polymer is prepared in the presence of an acid catalyst from compounds represented by Formulae 1, 2 and 3:

[R¹O]₃Si-X (1)

wherein X is a C₆-C₃₀ functional group containing at least one substituted or unsubstituted aromatic ring and R¹ is a C₁-C₆ alkyl group;

[R²O]₃Si-R³ (2)

wherein R² is a C₁-C₆ alkyl group and R³ is a C₁-C₁₂ alkyl group; and

[R⁴O]₃Si-Y-Si[OR ⁵]₃ (3)

wherein R⁴ and R⁵ are each independently a C₁-C₆ alkyl group, and Y is a linking group selected from the group consisting of aromatic rings, substituted or unsubstituted, linear or branched C₁-C₂₀ alkylene groups, C₁-C₂₀ alkylene groups containing an aromatic ring, a heterocyclic ring, an urea group or an isocyanurate group in the backbone and C₂-C₂₀ hydrocarbon groups containing at least one multiple bond and wherein the compound of Formula 1 is used in an amount of 0 to 90 parts by weight, the compound of Formula 2 is used in an amount of 5 to 90 parts by weight and the compound of Formula 3 is used in an amount of 5 to 90 parts by weight with respect to 100 parts by weight of the compounds Formulae 1, 2 and 3.

The organosilane polymer may be a polycondensation product of hydrolysates represented by Formulae 4, 5 and 6:

[HO]₃Si-X (4)

wherein X is a C₆-C₃₀ functional group containing at least one substituted or unsubstituted aromatic ring;

[HO]₃Si-R³ (5)

wherein R³ is a C₁-C₁₂ alkyl group; and

[HO]₃Si-Y-Si[OH] ₃ (6)

wherein Y is a linking group selected from the group consisting of aromatic rings, substituted or unsubstituted, linear or branched C₁-C₂₀ alkylene groups, C₁-C₂₀ alkylene groups containing an aromatic ring, a heterocyclic ring, an urea group or an isocyanurate group in the backbone, and C₂-C₂₀ hydrocarbon groups containing at least one multiple bond.

The polycondensation product may be a compound represented by Formula 7:

{(SiO_{1.5}-Y-SiO_{1.5})ₓ(R³SiO_{1.5})_{y}(XSiO_{1.5})_{z}}ₙ (7)

wherein x, y and z satisfy the relations 005 = x, y = 09,0 = z = 09 and x + y + z = 1; n is from 12 to 2,000; X is a C₆-C₃₀ functional group containing at least one substituted or unsubstituted aromatic ring; R³ is a C₁-C₆ alkyl group; and Y is a linking group selected from the group consisting of aromatic rings, substituted or unsubstituted, linear or branched C₁-C₂₀ alkylene groups, C₁-C₂₀ alkylene groups containing an aromatic ring, a heterocyclic ring, an urea group or an isocyanurate group in the backbone, and C₂-C₂₀ hydrocarbon groups containing at least one multiple bond.

The acid catalyst may be selected from the group consisting of nitric acid, sulfuric acid, hydrochloric acid, p-toluenesulfonic acid monohydrate, diethyl sulfate, and mixtures thereof.

The organosilane polymer may be prepared by mixing the compounds of Formulae 1, 2 and 3, and allowing the mixture to react in 100 to 900 parts by weight of a reaction solvent in the presence of 0001 to 5 parts by weight of the acid catalyst.

The organosilane polymer is present in an amount of 1 to 50 parts by weight, based on 100 parts by weight of the hardmask composition.

The hardmask composition of the present invention may further comprise at least one additive selected from crosslinkers, radical stabilizers, and surfactants.

The hardmask composition of the present invention further comprises at least one
compound selected from the group consisting of pyridinium *p*-toluenesulfonate, amidosulfobetain-16, (-)-camphor-10-sulfonic acid ammonium salt, ammonium formate, triethylammonium formate, trimethylammonium formate, tetramethylammonium formate, pyridinium formate, tetrabutylammonium formate, tetramethylammonium nitrate, tetrabutylammonium nitrate, tetrabutylammonium acetate, tetrabutylammonium azide, tetrabutylammonium benzoate, tetrabutylammonium bisulfate, tetrabutylammonium bromide, tetrabutylammonium chloride, tetrabutylammonium cyanide, tetrabutylammonium fluoride, tetrabutylammonium iodide, tetrabutylammonium sulfate, tetrabutylammonium nitrite, tetrabutylammonium *p*- toluenesulfonate, and tetrabutylammonium phosphate.

The hardmask composition of the present invention may further comprise at least one compound selected from the group consisting of pyridinium *p*-toluenesulfonate, amidosulfobetain-16,, (-)-camphor-10-sulfonic acid ammonium salt, ammonium formate, triethylammonium formate, trimethylammonium formate, tetramethylammonium formate, pyridinium formate, tetrabutylammonium formate, tetramethylammonium nitrate, tetrabutylammonium nitrate, tetrabutylammonium acetate, tetrabutylammonium azide, tetrabutylammonium benzoate, tetrabutylammonium bisulfate, tetrabutylammonium bromide, tetrabutylammonium chloride, tetrabutylammonium cyanide, tetrabutylammonium fluoride, tetrabutylammonium iodide, tetrabutylammonium sulfate, tetrabutylammonium nitrite, tetrabutylammonium *p* - toluenesulfonate, and tetrabutylammonium phosphate; and at least one additive selected from crosslinkers, radical stabilizers, and surfactants.

According to the present invention, there is provided a process for producing a semiconductor integrated circuit device using the hardmask composition.

Specifically, the process comprises the steps of (a) providing a material layer on a substrate, (b) forming a first hardmask layer composed of an organic material on the material layer, (c) coating the hardmask composition of the present invention on the first hardmask layer to form a second antireflective hardmask layer, (d) forming a radiation-sensitive imaging layer on the second antireflective hardmask layer, (e) patternwise exposing the imaging layer to radiation to form a pattern of radiation-exposed regions within the imaging layer, (f) selectively removing portions of the radiation-sensitive imaging layer and the second antireflective hardmask layer to expose portions of the first hardmask layer, (g) selectively removing portions of the patterned second antireflective hardmask layer and the first hardmask layer to expose portions of the material layer, and (h) etching the exposed portions of the material layer using the first hardmask layer as a mask to pattern the material layer.

The process of the present invention may further comprise the step of forming an antireflective coating on the second antireflective hardmask layer prior to step (d).

According to the present invention, there is provided a semiconductor integrated circuit device produced by the process.

### Brief Description of the Drawings

FIG. 1 is a schematic cross-sectional view of a multilayer structure consisting of an oxide film, an underlayer film for processing the oxide film, a hardmask for processing the underlayer film and a resist.
FIG. 2 shows specific exemplary compounds that can be represented by Formula 1.
FIG. 3 shows specific exemplary of compounds that can be represented by Formula 3.

### Best Mode for Carrying Out the Invention

Preferred embodiments of the present invention will now be described in greater detail.

The present invention provides a hardmask composition for processing a resist underlayer film, comprising an organosilane polymer according to claim 1 and a solvent wherein the organosilane polymer is prepared in the presence of an acid catalyst by polycondensation of hydrolysates of compounds represented by Formulae 1, 2 and 3:

[R¹O]₃Si-X (1)

wherein X is a C₆-C₃₀ functional group containing at least one substituted or unsubstituted aromatic ring and R¹ is a C₁-C₆ alkyl group;

[R²O]₃-Si-R³ (2)

wherein R² is a C₁-C₆ alkyl group and R³ is a C₁-C₁₂ alkyl group; and

[R⁴O]₃Si-Y-Si[OR⁵]₃ (3)

wherein R⁴ and R⁵ are each independently a C₁-C₆ alkyl group, and Y is a linking group selected from the group consisting of aromatic rings, substituted or unsubstituted, linear or branched C₁-C₂₀ alkylene groups, C₁-C₂₀ alkylene groups containing an aromatic ring, a heterocyclic ring, an urea group or an isocyanurate group in the backbone and C₂-C₂₀ hydrocarbon groups containing at least one multiple bond, and wherein the compound of Formula 1 is used in an amount of 0 to 90 parts by weight, the compound of Formula 2 is used in an amount of 5 to 90 parts parts by weight with respect to 100 parts by weíght of the compounds Formulae 1, 2 and 3.

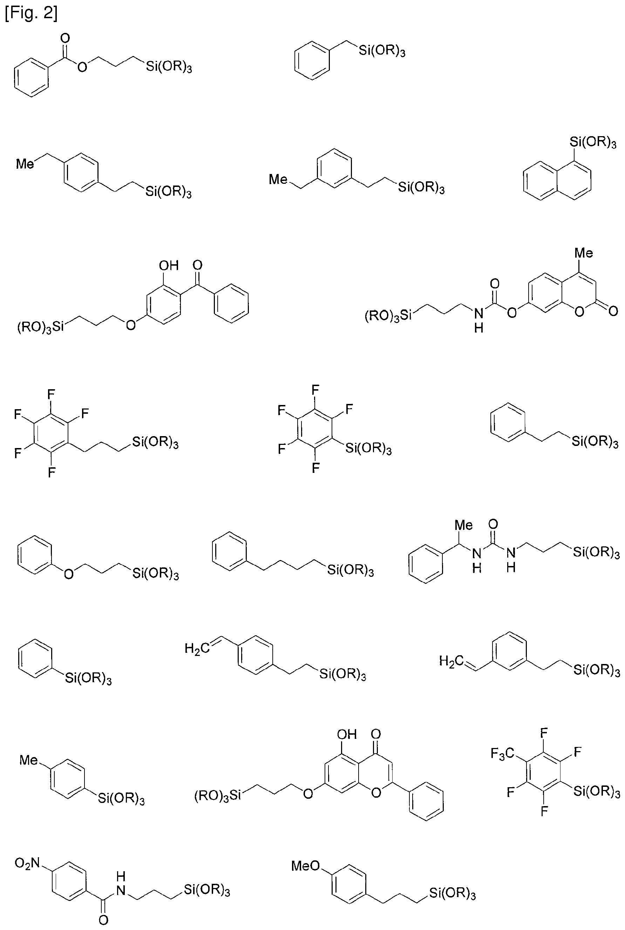

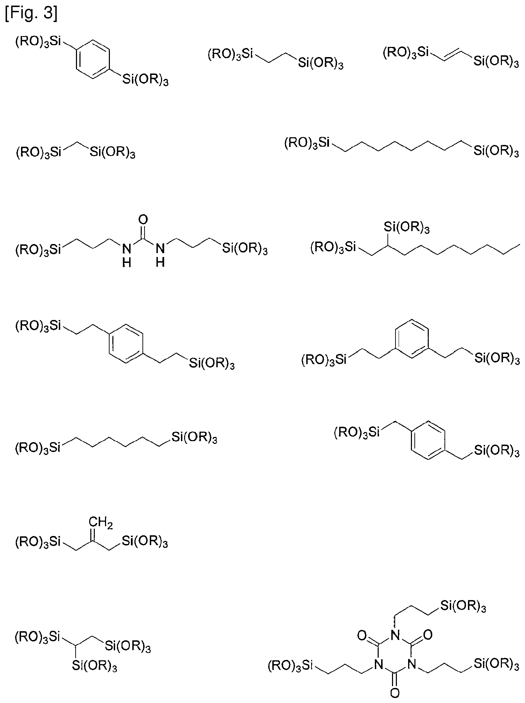

Specific exemplary compounds that can be represented by Formulae 1 and 3 are shown in FIGs. 2 and 3, respectively. In the figures, Me represents a methyl group and R represents a C₁-C₆ alkyl group.

The organosilane polymer may be prepared by mixing the compounds of Formulae 1,2 and 3, and allowing the mixture to react in 100 to 900 parts by weight of a reaction solvent in the presence of 0001 to 5 parts by weight of an acid catalyst.

The reaction solvent may be selected from the group consisting of acetone, tetrahydrofuran, benzene, toluene, diethyl ether, chloroform, dichloromethane, ethyl acetate, propylene glycol methyl ether, propylene glycol ethyl ether, propylene glycol propyl ether, propylene glycol methyl ether acetate, propylene glycol ethyl ether acetate, propylene glycol propyl ether acetate, ethyl lactate, γ-butyrolactone, and mixtures thereof.

The reaction of the compounds of Formulae 1, 2 and 3 in the presence of an acid catalyst gives hydrolysates represented by Formulae 4, 5 and 6, respectively.

[HO]₃Si-X (4)

wherein X is a C₆-C₃₀ functional group containing at least one substituted or unsubstituted aromatic ring;

[HO]₃Si-R ³ (5)

wherein R³ is a C₁-C₁₂ alkyl group; and

[HO]₃Si-Y-Si[OH] ₃ (6)

wherein Y is a linking group selected from the group consisting of aromatic rings, substituted or unsubstituted, linear or branched C₁-C₂₀ alkylene groups, C₁-C₂₀ alkylene groups containing an aromatic ring, a heterocyclic ring, an urea group or an isocyanurate group in the backbone, and C₂-C₂₀ hydrocarbon groups containing at least one multiple bond.

The organosilane polymer is a polycondensation product of the hydrolysates of Formulae 4, 5 and 6.

As the organosilane polymer prepared by polycondensation of the hydrolysates of Formulae 4, 5 and 6, there may be mentioned, for example, a compound represented by Formula 7:

{(SiO_{1.5}-Y-SiO_{1.5})ₓ(R³SiO_{1.5})_{y}(XSiO_{1.5})_{z}}ₙ (7)

wherein x, y and z satisfy the relations 005 = x, y = 09, 0 = z = 09 and x + y + z = 1; n is from 12 to 2,000; X is a C₆-C₃₀ functional group containing at least one substituted or unsubstituted aromatic ring; R³ is a C₁-C₆ alkyl group; and Y is a linking group selected from the group consisting of aromatic rings, substituted or unsubstituted, linear or branched C₁-C₂₀ alkylene groups, C₁-C₂₀ alkylene groups containing an aromatic ring, a heterocyclic ring, an urea group or an isocyanurate group in the backbone, and C₂-C₂₀ hydrocarbon groups containing at least one multiple bond.

Taking advantage of the ability of the substituted or unsubstituted aromatic group included in the compound of Formula 1 to absorb UV light in the deep UV (DUV) region, the hardmask composition of the present invention exhibits excellent antireflective properties. At the same time, the hardmask composition of the present invention has desired absorbance and refractive index at a particular wavelength by controlling the number of the substituted or unsubstituted aromatic groups in the organosilane polymer. It is necessary to use the compound of Formula 1 in an amount of 0 to 90 parts by weight, based on 100 parts by weight of the compounds of Formulae 1, 2 and 3. When the compound of Formula 1 is used in an amount not greater than 90 parts by weight, the antireflective properties of the hardmask composition are satisfactory due to the substituted or unsubstituted aromatic groups, thus avoiding the need to apply an additional antireflective coating. For the purpose of achieving improved absorbance and photo profile, an antireflective coating may be additionally used. No use of the compound of Formula 1 (*i.e.* 0%) requires an additional antireflective coating. Meanwhile, when the compound of Formula 1 is used in an amount exceeding 90 parts by weight, sufficient etch selectivity cannot be ensured due to low Si content. Suitable antireflective properties can be attained by controlling the relative amount of the compound of Formula 1.

On the other hand, an increase in the relative amount of the compound of Formula 2 used leads to better storage stability of the hardmask composition. It is necessary to use the compound of Formula 2 in an amount of 5 to 90 parts by weight, based on 100 parts by weight of the compounds of Formulae 1, 2 and 3. When the compound of Formula 2 is used in an amount of less than 5 parts by weight, the storage stability of the hardmask composition is impaired. Meanwhile, when the compound of Formula 2 is used in an amount of more than 90 parts by weight, the absorbance of the hardmask composition is lowered.

An increase in the relative amount of the compound of Formula 3 leads to an improvement in the etch resistance of the hardmask composition. It is necessary to use the
compound of Formula 3 in an amount of 5 to 90 parts by weight, based on 100 parts by weight of the compounds of Formulae 1, 2 and 3. The use of the compound of Formula 3 in an amount smaller than 5 parts by weight does not guarantee sufficient etch resistance of the hardmask composition due to the lowered Si content. Meanwhile, the use of the compound of Formula 3 in an amount exceeding 90 parts by weight causes a deterioration in the storage stability of the hardmask composition. As the hydrocarbon groups present between the S atoms limit the degree of freedom of Si-OH group, when the proportion of the compound of Formula 3 is relatively increased, the number of the Si-OH groups exposed to the surface increases. As a result, a thin film formed using the hardmask composition with higher proportion of Formula 3 shows a lower contact angle, which means the thin film is more hydrophilic. Accordingly, the hardmask composition of the present invention is effective in improving the interfacial compatibility of the thin film with an overlying antireflective coating by controlling hydrophilicity.

The acid catalyst is preferably selected from the group consisting of inorganic acids, such as nitric acid, sulfuric acid and hydrochloric acid, organic acids, such as *p -* toluenesulfonic acid monohydrate and diethyl sulfate, and mixtures thereof.

The hydrolysis or condensation reaction can be suitably controlled by varying the kind, the amount and the addition mode of the acid catalyst. In the formation reactions of the organosilane polymer, the acid catalyst may be used in an amount of 0001 and 5 parts by weight. The use of the acid catalyst in an amount smaller than 0001 parts by weight remarkably slows down the reaction rates, while the use of the acid catalyst in an amount larger than 5 parts by weight causes an excessive increase in the reaction rates, making it impossible to prepare polycondensation products having a desired molecular weight.

The amount of the organosilane polymer used is preferably 1 to 50 parts by weight, more preferably 1 to 30 parts by weight, based on 100 parts by weight of the hardmask composition. The use of the organosilane polymer outside the range defined above results in poor coatability of the hardmask composition.

The solvent used in the hardmask composition of the present invention may be a single solvent or a mixture of two or more solvents. When a mixture of two or more solvents is used in the hardmask composition of the present invention, at least one solvent is a high-boiling point solvent. The high-boiling point solvent acts to prevent formation of voids and allows a film to be dried at a low rate, thus achieving improved flatness of the film. As used herein, the term "high-boiling point solvent" refers to a solvent that is evaporated at a temperature lower than temperatures required to coat, dry and cure the hardmask composition of the present invention. Examples of solvents suitable for use in the hardmask composition of the present invention include acetone, tetrahydrofuran, benzene, toluene, diethyl ether, chloroform, dichloromethane, ethyl acetate, propylene glycol methyl ether, propylene glycol ethyl ether, propylene glycol propyl ether, propylene glycol methyl ether acetate, propylene glycol ethyl ether acetate, propylene glycol propyl ether acetate, ethyl lactate, g-butyrolactone, and mixtures thereof. The solvent may be the same as or different from the reaction solvent.

The hardmask composition of the present invention always comprises at least one compound selected from the group consisting of acid salts of organic bases, such as pyridinium *p*-toluenesulfonate, amidosulfobetain-16 and (-)-camphor-10-sulfonic acid ammonium salt, ammonium formate, triethylammonium formate, trimethylammonium formate, tetramethylammonium formate, pyridinium formate, tetrabutylammonium formate, tetramethylammonium nitrate, tetrabutylammonium nitrate, tetrabutylammonium acetate, tetrabutylammonium azide, tetrabutylammonium benzoate, tetrabutylammonium bisulfate, tetrabutylammonium bromide, tetrabutylammonium chloride, tetrabutylammonium cyanide, tetrabutylammonium fluoride, tetrabutylammonium iodide, tetrabutylammonium sulfate, tetrabutylammonium nitrite, tetrabutylammonium *p*-toluenesulfonate, and tetrabutylammonium phosphate. These compounds (crosslinking catalysts) play a role in promoting the crosslinking of the organosilane polymer to improve the etch resistance and solvent resistance of the hardmask composition. The compound is preferably used in an amount of 00001 to 001 parts by weight, based on 100 parts by weight of the organosilane polymer. Below 00001 parts by weight, the above effects cannot be expected. Above 001 parts by weight, the storage stability of the hardmask composition is insufficient.

If necessary, the hardmask composition of the present invention may further comprise the crosslinking catalyst and at least one additive selected from crosslinkers, radical stabilizers and surfactants.

The present invention also provides a process for producing a semiconductor integrated circuit device, the process comprising the steps of (a) providing a material layer on a substrate, (b) forming a first hardmask layer composed of an organic material on the material layer, (c) coating the hardmask composition of the present invention on the first hardmask layer to form a second antireflective hardmask layer, (d) forming a radiation-sensitive imaging layer on the second antireflective hardmask layer, (e) patternwise exposing the imaging layer to radiation to form a pattern of radiation-exposed regions within the imaging layer, (f) selectively removing portions of the radiation-sensitive imaging layer and the second antireflective hardmask layer to expose portions of the first hardmask layer, (g) selectively removing portions of the patterned second antireflective hardmask layer and the first hardmask layer to expose portions of the material layer, and (h) etching the exposed portions of the material layer using the first hardmask layer as a mask to pattern the material layer.

When the compound of Formula 1 is not used or it is intended to improve the absorbance and photo profile, an antireflective coating may be formed on the second antireflective hardmask layer prior to step (d).

The composition and the process of the present invention may be employed in the formation of patterned material layer structures (e.g., metal wiring lines, contact holes and biases), insulating sections (e.g., damascene trenches and shallow trench isolation), and trenches for capacitor structures (e.g., trenches used in the design of integrated circuit devices). The composition and the process of the present invention are particularly suitable for the formation of patterned oxide, nitride, polysilicon and chromium layers.

The present invention also provides a semiconductor integrated circuit device produced by the process.

### Mode for the Invention

Hereinafter, the present invention will be explained in more detail with reference to the following examples. However, these examples are given for the purpose of illustration only and are not to be construed as limiting the scope of the invention.

### EXAMPLES

### [Comparative Example 1]

1,750g of methyltrimethoxysilane, 340g of phenyltrimethoxysilane and 313g of trimethoxysilane were dissolved in 5,600g of propylene glycol monomethyl ether acetate (PGMEA) in a 10-liter four-neck flask equipped with a mechanical agitator, a condenser, a dropping funnel and a nitrogen inlet tube, and then 925g of an aqueous nitric acid solution (1,000 ppm) was added thereto. After the resulting mixture was allowed to react at 60°C for one hour, the formed methanol was removed under reduced pressure. The reaction was continued for one week while maintaining the reaction temperature at 50°C. After completion of the reaction, hexane was added to the reaction mixture to precipitate the polymer of Formula 8:

{(HSiO_{1.5})₀₁₅(CH₃SiO_{1.5})₀₇₅(PhSiO_{1.5})₀₁}ₙ (n = 50-300) (8)

2.0g of the polymer was added to 50g of PGMEA and 50g of ethyl lactate to prepare a dilute solution of the polymer. 0002g of pyridinium *p*-toluenesulfonate was added to the dilute solution. The resulting solution was spin-coated on a silicon wafer, followed by baking at 240°C for 60 seconds to form a 500 Åthick film.

### [Example 1]

1,375g of methyltrimethoxysilane, 286g of phenyltrimethoxysilane and 740g of bis(trimethoxysilyl)methane were dissolved in 5,600g of PGMEA in a 10-liter four-neck flask equipped with a mechanical agitator, a condenser, a dropping funnel and a nitrogen inlet tube, and then 654g of an aqueous nitric acid solution (1,000 ppm) was added thereto. After the resulting mixture was allowed to react at 50°C for one hour, the formed methanol was removed under reduced pressure. The reaction was continued for one week while maintaining the reaction temperature at 80°C. After completion of the reaction, hexane was added to the reaction mixture to precipitate the polymer of Formula 9:

{(SiO_{1.5}CH₂SiO_{1.5})₀₂(CH₃SiO_{1.5})₀₇(PhSiO_{1.5})₀₁ }ₙ (n = 50-400) (9)

The polymer was filtered to obtain a sample. 2.0g of the sample was added to 100g of PGMEA to prepare a dilute solution. 0002g of pyridinium *p*-toluenesulfonate was added to the dilute solution. The resulting solution was spin-coated on a silicon wafer, followed by baking at 240°C for 60 seconds to form a 500 Athick film.

### [Example 2]

1,632g of methyltrimethoxysilane and 768g of bis(trimethoxysilyl)methane were dissolved in 5,600g of PGMEA in a 10-liter four-neck flask equipped with a mechanical agitator, a condenser, a dropping funnel and a nitrogen inlet tube, and then 654g of an aqueous nitric acid solution (1,000 ppm) was added thereto. After the resulting mixture was allowed to react at 50°C for one hour, the formed methanol was removed under reduced pressure. The reaction was continued for one week while maintaining the reaction temperature at 50°C. After completion of the reaction, hexane was added to the reaction mixture to precipitate the polymer of Formula 10:

{(SiO_{1.5}CH₂SiO_{1.5})₀₂(CH₃SiO_{1.5})₀₈}ₙ(n = 50-400) (10)

The polymer was filtered to obtain a sample. 2.0g of the sample was added to 100g of PGMEA to prepare a dilute solution. 0002g of pyridinium *p*-toluenesulfonate was added to the dilute solution. The resulting solution was spin-coated on a silicon wafer, followed by baking at 240°C for 60 seconds to form a 500 Athick film.

### [Example 3]

686g of methyltrimethoxysilane and 1,714g of bis(trimethoxysilyl)methane were dissolved in 5,600g of PGMEA in a 10-liter four-neck flask equipped with a mechanical agitator, a condenser, a dropping funnel and a nitrogen inlet tube, and then 462g of an aqueous nitric acid solution (1,000 ppm) was added thereto. After the resulting mixture was allowed to react at 50°C for one hour, the formed methanol was removed under reduced pressure. The reaction was continued for 3 days while maintaining the reaction temperature at 50°C. After completion of the reaction, hexane was added to the reaction mixture to precipitate the polymer of Formula 11:

{(SiO_{1.5}CH₂SiO_{1.5})₀₅(CH₃SiO_{1.5})₀₅ }ₙ (n = 50-400) (11)

The polymer was filtered to obtain a sample. 2.0g of the sample was added to 100g of PGMEA to prepare a dilute solution. 0002g of pyridinium *p*-toluenesulfonate was added to the dilute solution. The resulting solution was spin-coated on a silicon wafer, followed by baking at 240°C for 60 seconds to form a 500 Athick film.

### [Example 4]

189g of phenyltrimethoxysilane, 519g of methyltrimethoxysilane and 1,691g of bis(triethoxysilyl)ethane were dissolved in 5,600g of PGMEA in a 10-liter four-neck flask equipped with a mechanical agitator, a condenser, a dropping funnel and a nitrogen inlet tube, and then 541g of an aqueous nitric acid solution (1,000 ppm) was added thereto. After the resulting mixture was allowed to react at 50°C for one hour, the formed methanol and ethanol were removed under reduced pressure. The reaction was continued for 3 days while maintaining the reaction temperature at 50°C. After completion of the reaction, hexane was added to the reaction mixture to precipitate the polymer of Formula 12:

{(SiO_{1.5}(CH₂)₂SiO_{1.5})₀₅(CH₃SiO_{1.5})₀₄(PhSiO_{1.5})₀₁}ₙ (n = 50-400) (12)

The polymer was filtered to obtain a sample. 2.0g of the sample was added to 100g of PGMEA to prepare a dilute solution. 0.002g of pyridinium *p*-toluenesulfonate was added to the dilute solution. The resulting solution was spin-coated on a silicon wafer, followed by baking at 240°C for 60 seconds to form a 500 Athick film.

### [Experimental Example 1]

The solutions prepared in Comparative Example 1 and Examples 1 to 4 were tested for storage stability. Three samples of each solution were stored at 40°C. At intervals of 10 days, the molecular weight of the polymer in the samples and the thickness of the films obtained after coating of the samples were measured. The results are shown in Table 1.

Table 1

**[Table 1]**

| Sample | After 10 days | | After 20 days | | After 30 days | |
|---|---|---|---|---|---|---|
| | Normalized molecular weight | Thickness (Å) | Normalized molecular weight | Thickness (Å) | Normalized molecular weight | Thickness (Å) |
| Comparative Example 1 | 1.1 | 512 | 1.8 | 532 | Particles observed | Poor coatability |
| Example 1 | 1.0 | 502 | 1.0 | 503 | 1.0 | 505 |
| Example 2 | 1.0 | 503 | 1.0 | 504 | 1.0 | 506 |
| Example 3 | 1.0 | 503 | 1.0 | 503 | 1.0 | 505 |
| Example 4 | 1.0 | 502 | 1.0 | 503 | 1.0 | 503 |

The normalized molecular weight as shown in Table 1 refers to a value obtained by dividing the molecular weight of the corresponding polymer measured after the indicated time of storage by the molecular weight of the polymer measured immediately after the preparation of the hardmask composition. An increase in the molecular weight of the polymer prepared in Comparative Example 1 after the indicated time intervals of storage was observed. In contrast, the molecular weights of the polymers prepared in Examples 1 to 4 were maintained even after the indicated time intervals, indicating high storage stability of the polymers.

The polymers prepared using a disilane monomer in Examples 1 to 4 had a high Si content without the use of any additional silane compound containing hydrogen and were highly stable during storage.

### [Experimental Example 2]

The films formed in Comparative Example 1 and Examples 1 to 4 were measured for refractive index (n) and extinction coefficient (k) using an Ellipsometer (J. A. Woollam). The results are shown in Table 2.

Table 2

**[Table 2]**

| Sample used in the formation of film | Optical properties (193 nm) | |
|---|---|---|
| | Refractive index (n) | Extinction coefficient (k) |
| Comparative Example 1 | 1.71 | 0.23 |
| Example 1 | 1.70 | 0.19 |
| Example 2 | 1.56 | 0.00 |
| Example 3 | 1.59 | 0.00 |
| Example 4 | 1.69 | 0.15 |

As can be seen from the results of Table 2, taking advantage of the ability of the substituted or unsubstituted aromatic groups included in the polymers to absorb UV light in the deep UV (DUV) region, the solutions prepared in Examples 1 and 4 showed antireflective properties.

### [Experimental Example 3]

The films formed in Comparative Example 1 and Examples 1 to 4 were measured for contact angle with water using a contact angle measurement system (Phoenix 300 plus, SEO). 10 *µ*ℓ of water was dropped onto the surface (five points) of each of the films. The angles between the surface of the film and the drops of water were measured. The results are shown in Table 3.

Table 3

**[Table 3]**

| Contact angle | Point 1 (°) | Point 2 (°) | Point 3 (°) | Point 4 (°) | Point 5 (°) | Average (°) |
|---|---|---|---|---|---|---|
| Comparative Example 1 | 87.2 | 90.5 | 87.2 | 86.3 | 88.7 | 87.9 |
| Example 1 | 84.3 | 80.6 | 89.4 | 84.3 | 82.2 | 84.1 |
| Example 2 | 82.0 | 82.0 | 84.3 | 79.2 | 80.6 | 81.6 |
| Example 3 | 66.2 | 72.4 | 72.4 | 78.4 | 74.9 | 72.8 |
| Example 4 | 73.6 | 74.9 | 74.9 | 74.9 | 73.6 | 74.3 |

The results of Table 3 demonstrate that polymers having desired surface characteristics can be readily synthesized by appropriately optimizing the feeding ratio of the compounds of Formulae 1, 2 and 3. Particularly, as the proportion of the compound of Formula 3 in the polymers increased, the surface characteristics of the polymers were more hydrophilic.

### [Experimental Example 4]

Bulk dry etching without any pattern was performed on the films of Comparative Example 1 and Examples 1 to 4 for 100 seconds under the following plasma conditions: 90 mT, 400 W/250W, 24 N₂, 12 O₂, 500 Ar. After etching, the thickness of the films was measured to calculate etch rates per unit time. N₂ and Ar were used as flowing gases and O₂ was used as a main etching gas. The results are shown in Table 4.

Table 4

**[Table 4]**

| Sample | Si content (%) | Thickness (Å) after etching | Thickness variation (Å) | Etch rate (Å/sec.) |
|---|---|---|---|---|
| Comparative Example 1 | 41 | 245 | 255 | 2.55 |
| Example 1 | 41 | 264 | 236 | 2.36 |
| Example 2 | 43 | 316 | 184 | 1.84 |
| Example 3 | 45 | 369 | 131 | 1.31 |
| Example 4 | 41 | 310 | 190 | 1.90 |

The polymers prepared using a disilane monomer in Examples 1 to 4 had almost the same Si contents as the polymer prepared in Comparative Example 1. The results of Table 4 demonstrate that films having a desired Si content can be readily synthesized by appropriately optimizing the feeding ratio of the compounds of Formulae 1, 2 and 3. In addiction, it was confirmed that the films showed improved etch resistance against O₂ plasma as the Si content increased (Example 1, 2 and 3). Although the Si content of the film formed using a disilane monomer in Example 4 was the same as that of the film formed Comparative Example 1, the film formed in Example 4 showed better etch resistance due to its more resistant structure.

### [Experimental Example 5]

ArF photoresists were coated on each of the films formed in Comparative Example 1 and Examples 1 to 4,, baked at 110°C for 60 seconds, exposed to light using an ArF exposure system (ASML1250, NA 082), and developed with an aqueous solution of TMAH (2.38 wt%) to form an 80-nm line and space pattern. An additional antireflective coating was formed on the films formed in Examples 2 and 3. The patterns were observed using a CD-SEM. The patterns were measured for exposure latitude (EL) margin as a function of exposure energy and depth of focus (DoF) margin as a function of the distance from a light source. The results are recorded in Table 5.

Table 5

**[Table 5]**

| Sample used in the formation of film | Pattern Characteristics | |
|---|---|---|
| | EL margin (ΔmJ/exposure energy mJ) | DoF margin (µm) |
| Comparative Example 1 | 0.2 | 0.2 |
| Example 1 | 0.2 | 0.2 |
| Example 2 | 0.2 | 0.2 |
| Example 3 | 0.2 | 0.2 |
| Example 4 | 0.2 | 0.2 |

All the examples showed good photo profile in terms of exposure latitude (EL) margin and depth of focus (DoF) margin. From the results of Table 5, it could be confirmed that the introduction of the disilane monomer in the polymers prepared in Examples 1 to 4 did not adversely affect the photo profile of the patterns.

### [Experimental Example 6]

The patterned specimens obtained in Experimental Example 5 were sequentially dryetched using CFₓ plasma, O₂ plasma and CFₓ plasma. The remaining organic materials were completely removed using O₂, and the cross sections of the etched specimens were observed by FE-SEM. The results are listed in Table 6.

Table 6

**[Table 6]**

| Sample used in the formation of film | Shape of pattern after etching |
|---|---|
| Comparative Example 1 | Vertical |
| Example 1 | Vertical |
| Example 2 | Vertical |
| Example 3 | Vertical |
| Example 4 | Vertical |

The shape of the patterns after etching was vertical, indicating good etching characteristics of the specimens. These results reveal that the introduction of the disilane monomer in the polymers prepared in Examples 1 to 4 had no bad influence on the etch resistance, etch selectivity and etch profile of the masks.

The disilane monomer used to prepare the polymers in Examples 1 to 4 increases the S content per repeating units and the number of reactive functional groups when compared to the alkyltrialkoxysilane monomer used in Comparative Example 1, thus dramatically increasing the molecular weights of the polymers during condensation. The films formed using the polymers showed good storage stability and improved etch resistance due to their stable structure.

In addiction, it was confirmed that a thin film formed using the hardmask composition with higher proportion of Formula 3 shows a lower contact angle, which means the thin film is more hydrophilic. Accordingly, the hardmask composition of the present invention is effective in improving the interfacial compatibility of the thin film with an overlying antireflective coating by controlling hydrophilicity.

### Industrial Applicability

*As apparent from the above description, the* hardmask composition of the present *invention has a high silicon content without using* any additional silane compound containing hydrogen and exhibits good storage stability. In addiction, since the hardmask composition of the present invention exhibits excellent film characteristics and allows a good pattern to be transferred to a material layer due to its satisfactory hardmask characteristics.

Particularly, the hardmask composition of the present invention can be used to form a hardmask with improved etch resistance against O₂ plasma gas upon subsequent etching for patterning. Furthermore, the hardmask composition of the present invention can be used to form a highly hydrophilic thin film, thus being effective in improving the interfacial compatibility of the thin film with an overlying antireflective coating.

## Claims

1. A hardmask composition for processing a resist underlayer film, comprising an organosilane polymer and a solvent or a mixture of solvents wherein the organosilane polymer is prepared in the presence of an acid catalyst from compounds represented by Formulae 1, 2 and 3:
[R¹O]₃Si-X (1)
wherein X is a C₆-C₃₀ functional group containing at least one substituted or unsubstituted aromatic ring and R¹ is a C₁-C₆ alkyl group;
[R²O]₃Si-R³ (2)
wherein R² is a C₁-C₆ alkyl group and R³ is a C₁-C₁₂ alkyl group; and
[R⁴O]₃Si-Y-Si[OR⁵]₃ (3)
wherein R⁴ and R⁵ are each independently a C₁-C₆ alkyl group, and Y is a linking group selected from the group consisting of aromatic rings, substituted or unsubstituted, linear or branched C₁-C₂₀ alkylene groups, C₁-C₂₀ alkylene groups containing an aromatic ring, a heterocyclic ring, an urea group or an isocyanurate group in the backbone and C₂-C₂₀ hydrocarbon groups containing at least one multiple bond, and
wherein the compound of Formula 1 is used in an amount of 0 to 90 parts by weight, the compound of Formula 2 is used in an amount of 5 to 90 parts by weight and the compound of Formula 3 is used in an amount of 5 to 90 parts by weight with respect to 100 parts by weight of the compounds of Formulae 1, 2, and 3; and
wherein the composition further comprises at least one compound selected from the group consisting of pyridinium *p*-toluenesulfonate, amidosulfobetain-16, (-)-camphor-10-sulfonic acid ammonium salt, ammonium formate,
triethylammonium formate, trimethylammonium formate, tetramethylammonium formate, pyridinium formate, tetrabutylammonium formate, tetramethylammonium nitrate, tetrabutylammonium nitrate, tetrabutylammonium acetate, tetrabutylammonium azide, tetrabutylammonium benzoate,
tetrabutylammonium bisulfate, tetrabutylammonium bromide,
tetrabutylammonium chloride, tetrabutylammonium cyanide,
tetrabutylammonium fluoride, tetrabutylammonium iodide, tetrabutylammonium sulfate, tetrabutylammonium nitrite, tetrabutylammonium *p*-toluenesulfonate, and
tetrabutylammonium phosphate.

2. The hardmask composition according to claim 1, wherein the organosilane polymer is a polycondensation product of hydrolysates represented by Formulae 4, 5 and 6:
[HO]₃Si-X (4)
wherein X is a C₆-C₃₀ functional group containing at least one substituted or unsubstituted aromatic ring;
[HO]₃Si-R³ (5)
wherein R³ is a C₁-C₁₂ alkyl group; and
[HO]₃Si-Y-Si[OH]₃ (6)
wherein Y is a linking group selected from the group consisting of aromatic rings, substituted or unsubstituted, linear or branched C₁-C₂₀ alkylene groups, C₁-C₂₀ alkylene groups containing an aromatic ring, a heterocyclic ring, an urea group or an isocyanurate group in the backbone and C₂-C₂₀ hydrocarbon groups containing at least one multiple bond.

3. The hardmask composition according to claim 2, wherein the polycondensation product is a compound represented by Formula 7:
{(SiO_{1.5}-Y-SiO_{1.5})ₓ(R³SiO_{1.5})_{y}(XSiO_{1.5})_{z}}ₙ (7)
wherein x, y and z satisfy the relations 0.05 = x, y = 0.9, 0 = z = 0.9 and x + y + z = 1; n is from 12 to 2,000; X is a C₆-C₃₀ functional group containing at least one substituted or unsubstituted aromatic ring; R³ is a C₁-C₆ alkyl group; and Y is a linking group selected from the group consisting of aromatic rings, substituted or unsubstituted, linear or branched C₁-C₂₀ alkylene groups, C₁-C₂₀ alkylene groups containing an aromatic ring, a heterocyclic ring, an urea group or an isocyanurate group in the backbone, and C₂-C₂₀ hydrocarbon groups containing at least one multiple bond.

4. The hardmask composition according to claim 1, wherein the organosilane polymer is prepared by mixing 0 to 90 parts by weight of the compound of Formula 1, 5 to 90 parts by weight of the compound of Formula 2 and 5 to 90 parts by weight of the compound of Formula 3 with respect to 100 parts by weight of the compounds of Formulae 1, 2 and 3, and allowing the mixture to react in 100 to 900 parts by weight of a reaction solvent in the presence of 0.001 to 5 parts by weight of the acid catalyst.

5. The hardmask composition according to claim 1, wherein the acid catalyst is selected from the group consisting of nitric acid, sulfuric acid, hydrochloric acid, p-toluenesulfonic acid monohydrate, diethyl sulfate, and mixtures thereof.

6. The hardmask composition according to claim 1, wherein the organosilane polymer is present in an amount of 1 to 50 parts by weight, based on 100 parts by weight of the hardmask composition.

7. The hardmask composition according to claim 1, further comprising at least one additive selected from crosslinkers, radical stabilizers, and surfactants.

8. A process for producing a semiconductor integrated circuit device, the process comprising the steps of:
(a) providing a material layer on a substrate;
(b) forming a first hardmask layer composed of an organic material on the material layer;
(c) coating the hardmask composition according to claim 1 on the first hardmask layer to form a second antireflective hardmask layer;
(d) forming a radiation-sensitive imaging layer on the second antireflective hardmask layer;
(e) patternwise exposing the imaging layer to radiation to form a pattern of radiation-exposed regions within the imaging layer;
(f) selectively removing portions of the radiation-sensitive imaging layer and the second antireflective hardmask layer to expose portions of the first hardmask layer;
(g) selectively removing portions of the patterned second antireflective hardmask layer and the first hardmask layer to expose portions of the material layer; and
(h) etching the exposed portions of the material layer to pattern the material layer.

9. The process according to claim 8, further comprising the step of forming an additional antireflective coating on the second antireflective hardmask layer prior to step (d).

10. A semiconductor integrated circuit device produced by the process according to claim 8.

11. A semiconductor integrated circuit device produced by the process according to claim 9.

## Patentansprüche

1. Hartmaskenzusammensetzung zum Verarbeiten eines Resistunterschichtfilms, umfassend ein Organosilan-Polymer und ein Lösungsmittel oder ein Gemisch von Lösungsmitteln, wobei das Organosilan-Polymer in Anwesenheit eines Säurekatalysators aus Verbindungen, die durch die Formeln 1, 2 und 3 dargestellt werden, hergestellt ist:
[R¹O]₃Si-X (1)
wobei X eine C₆-C₃₀-funktionelle Gruppe ist, die wenigstens einen substituierten oder unsubstituierten aromatischen Ring enthält, und R¹ eine C₁-C₆-Alkylgruppe ist;
[R²O]₃Si-R³ (2)
wobei R² eine C₁-C₆-Alkylgruppe ist und R³ eine C₁-C₁₂-Alkylgruppe ist; und
[R⁴O]₃Si-Y-Si[OR⁵]₃ (3)
wobei R⁴ und R⁵ jeweils unabhängig eine C₁-C₆-Alkylgruppe sind, und Y eine Verbindungsgruppe ist, ausgewählt aus der Gruppe bestehend aus aromatischen Ringen, substituierten oder unsubstituierten, linearen oder verzweigten C₁-C₂₀-Alkylengruppen, C₁-C₂₀-Alkylengruppen, die einen aromatischen Ring, einen heterocyclischen Ring, eine Harnstoffgruppe oder eine Isocyanuratgruppe im Grundgerüst enthalten, und C₂-C₂₀-Kohlenwasserstoffgruppen, die wenigstens eine Mehrfachbindung enthalten, und
wobei die Verbindung der Formel 1 in einer Menge von 0 bis 90 Gewichtsteilen verwendet wird, die Verbindung der Formel 2 in einer Menge von 5 von 90 Gewichtsteilen verwendet wird, und die Verbindung der Formel 3 in einer Menge von 5 bis 90 Gewichtsteilen verwendet wird, bezüglich 100 Gewichtsteilen der Verbindungen der Formeln 1, 2 und 3; und wobei die Zusammensetzung weiterhin wenigstens eine Verbindung umfasst, ausgewählt aus der Gruppe bestehend aus Pyridinium-*p*-toluolsulfonat, Amidosulfobetain-16, (-)-Camphor-10-sulfonsäureammoniumsalz, Ammoniumformiat, Triethylammoniumformiat, Trimethylammoniumformiat, Tetramethylammoniumformiat, Pyridiniumformiat, Tetrabutylammoniumformiat, Tetramethylammoniumnitrat, Tetrabutylammoniumnitrat, Tetrabutylammoniumacetat, Tetrabutylammoniumazid, Tetrabutylammoniumbenzoat,Tetrabutylammoniumbisulfat, Tetrabutylammoniumbromid, Tetrabutylammoniumchlorid, Tetrabutylammoniumcyanid, Tetrabutylammoniumfluorid, Tetrabutylammoniumiodid, Tetrabutylammoniumsulfat, Tetrabutylammoniumnitrit, Tetrabutylammonium-*p*-toluolsulfonat, und Tetrabutylammoniumphosphat.

2. Hartmaskenzusammensetzung gemäß Anspruch 1, wobei das Organosilan-Polymer ein Polykondensationsprodukt von Hydrolysaten ist, die durch die Formeln 4, 5 und 6 dargestellt werden:
[HO]₃Si-X (4)
wobei X eine C₆-C₃₀-funktionelle Gruppe ist, die wenigstens einen substituierten oder unsubstitutierten aromatischen Ring enthält;
[HO]₃Si-R³ (5)
wobei R³ eine C₁-C₁₂-Alkylgruppe ist; und
[HO]₃Si-Y-Si[OH]₃ (6) wobei Y eine Verbindungsgruppe ist, ausgewählt aus der Gruppe bestehend aus aromatischen Ringen, substituierten oder unsubstituierten, linearen oder verzweigten C₁-C₂₀-Alkylengruppen, C₁-C₂₀-Alkylengruppen, die einen aromatischen Ring, einen heterocyclischen Ring, eine Harnstoffgruppe oder eine Isocyanuratgruppe im Grundgerüst enthalten, und C₂-C₂₀-Kohlenwasserstoffgruppen, die wenigstens eine Mehrfachbindung enthalten.

3. Hartmaskenzusammensetzung gemäß Anspruch 2, wobei das Polykondensationsprodukt eine Verbindung ist, die durch die Formel 7 dargestellt wird:
{(SiO_{1.5}-Y-SiO_{1.5})ₓ(R³SiO_{1.5})_{y}(XSiO_{1.5})_{z}}ₙ (7)
wobei x, y und z die Beziehungen 0.05 = x, y = 0.9, 0 = z = 0.9 und x + y + z = 1 erfüllen; n von 12 bis 2.000 ist; X eine C₆-C₃₀-funktionelle Gruppe ist, die wenigstens einen substitutierten oder unsubstituierten aromatischen Ring enthält;
R³ eine C₁-C₆-Alkylgruppe ist; und Y eine Verbindungsgruppe ist, ausgewählt aus der Gruppe bestehend aus aromatischen Ringen, substituierten oder unsubstituierten, linearen oder verzweigten C₁-C₂₀-Alkylengruppen, C₁-C₂₀-Alkylengruppen, die einen aromatischen Ring, einen heterocyclischen Ring, eine Harnstoffgruppe oder eine Isocyanuratgruppe im Grundgerüst enthalten,
und C₂-C₂₀-Kohlenwasserstoffgruppen, die wenigstens eine Mehrfachbindung enthalten.

4. Hartmaskenzusammensetzung gemäß Anspruch 1, wobei das Organosilan-Polymer hergestellt ist durch Mischen von 0 bis 90 Gewichtsteilen der Verbindung der Formel 1, 5 bis 90 Gewichtsteilen der Verbindung der Formel 2 und 5 bis 90 Gewichtsteilen der Verbindung der Formel 3, bezüglich 100 Gewichtsteilen der Verbindungen der Formeln 1, 2 und 3, und Reagierenlassen des Gemisches in 100 bis 900 Gewichtsteilen eines Reaktionslösungsmittels in Anwesenheit von 0,001 bis 5 Gewichtsteilen des Säurekatalysators.

5. Hartmaskenzusammensetzung gemäß Anspruch 1, wobei der Säurekatalysator ausgewählt ist aus der Gruppe bestehend aus Salpetersäure, Schwefelsäure, Chlorwasserstoffsäure, *p*-Toluolsulfonsäure-Monohydrat, Diethylsulfat und Gemischen davon.

6. Hartmaskenzusammensetzung gemäß Anspruch 1, wobei das Organosilan-Polymer in einer Menge von 1 bis 50 Gewichtsteilen vorliegt, bezogen auf 100 Gewichtsteile der Hartmaskenzusammensetzung.

7. Hartmaskenzusammensetzung gemäß Anspruch 1, weiterhin umfassend wenigstens ein Additiv ausgewählt aus Vernetzern, Radikalstabilisatoren, und oberflächenaktiven Mitteln.

8. Verfahren zur Herstellung eines integrierten Halbleiterschaltungsbauelements bzw. einer integrierten Halbleiterschaltungsvorrichtung, wobei das Verfahren die Schritte umfasst:
(a) Bereitstellen einer Materialschicht auf einem Substrat;
(b) Bilden einer ersten, aus einem organischen Material zusammengesetzten Hartmaskenschicht auf der Materialschicht;
(c) Beschichten der Hartmaskenzusammensetzung gemäß Anspruch 1 auf der ersten Hartmaskenschicht zur Bildung einer zweiten antireflektierenden Hartmaskenschicht;
(d) Bilden einer strahlungssensitiven Bildgebungsschicht auf der zweiten antireflektierenden Hartmaskenschicht;
(e) mustermäßiges einer Strahlung Aussetzen der Bildgebungsschicht zur Bildung eines Musters von der Strahlung ausgesetzten Bereichen innerhalb der Bildgebungsschicht;
(f) selektives Entfernen von Teilen der strahlungssensitiven Bildgebungsschicht und der zweiten antireflektierenden Hartmaskenschicht, um Teile der ersten Hartmaskenschicht freizulegen;
(g) selektives Entfernen von Teilen der gemusterten zweiten antireflektierenden Hartmaskenschicht und der ersten Hartmaskenschicht, um Teile der Materialschicht freizulegen; und
(h) Ätzen der freigelegten Teile der Materialschicht, um die Materialschicht zu mustern.

9. Verfahren gemäß Anspruch 8, weiterhin umfassend den Schritt eines Bildens einer zusätzlichen antireflektierenden Beschichtung auf der zweiten antireflektierenden Hartmaskenschicht vor Schritt (d).

10. Integriertes Halbleiterschaltungsbauelement bzw. integrierte Halbleiterschaltungsvorrichtung, hergestellt durch das Verfahren gemäß Anspruch 8.

11. Integriertes Halbleiterschaltungsbauelement bzw. integrierte Halbleiterschaltungsvorrichtung, hergestellt durch das Verfahren gemäß Anspruch 9.

## Revendications

1. Composition de masque dur pour le traitement d'un film de sous-couche de réserve, comprenant un polymère d'organosilane et un solvant ou un mélange de solvants, dans laquelle le polymère d'organosilane est préparé en présence d'un catalyseur acide à partir de composés représentés par les Formules 1, 2 et 3 :
[R¹O]₃Si-X (1)
dans laquelle X est un groupe fonctionnel en C₆-C₃₀ contenant au moins un noyau aromatique substitué ou non substitué, et R¹ est un groupe alkyle en C₁₋₆;
[R²O] ₃Si-R³ (2)
dans laquelle R² est un groupe alkyle en C₁₋₆, et R³ est un groupe alkyle en C₁-C₁₂ ; et
[R⁴O]₃Si-Y-Si[OR⁵]₃ (3)
dans laquelle R⁴ et R⁵ représentent chacun indépendamment de l'autre un groupe alkyle en C₁₋₆, et Y est un groupe de liaison choisi dans le groupe consistant en les noyaux aromatiques, les groupes alkylène en C₁-C₂₀ à chaîne droite ou ramifiée, substitués ou non substitués, les groupes alkylène en C₁-C₂₀ contenant dans le squelette un noyau aromatique, un noyau hétérocyclique, un groupe urée ou un groupe isocyanurate, et les groupes hydrocarbonés en C₂-C₂₀ contenant au moins une liaison multiple, et
dans laquelle le composé de Formule 1 est utilisé en une quantité de 0 à 90 parties en poids, le composé de Formule 2 est utilisé en une quantité de 5 à 90 parties en poids, et le composé de Formule 3 est utilisé en une quantité de 5 à 90 parties en poids, pour 100 parties en poids des composés de Formules 1, 2 et 3 ; et
la composition comprenant en outre au moins un composé choisi dans le groupe consistant en le p-toluènesulfonate de pyridinium, l'amidosulfobétaïne-16, le sel d'ammonium de l'acide (-)-campho-10-sulfonique, le formiate d'ammonium, le formiate de triéthylammonium, le formiate de triméthylammonium, le formiate de tétraméthylammonium, le formiate de pyridinium, le formiate de tétrabutylammonium, le nitrate de tétraméthylammonium, le nitrate de tétrabutylammonium, l'acétate de tétrabutylammonium, l'azoture de tétrabutylammonium, le benzoate de tétrabutylammonium, le bisulfate de tétrabutylammonium, le bromure de tétrabutylammonium, le chlorure de tétrabutylammonium, le cyanure de tétrabutylammonium, le fluorure de tétrabutylammonium, l'iodure de tétrabutylammonium, le sulfate de tétrabutylammonium, le nitrite de tétrabutylammonium, le p-toluènesulfonate de tétrabutylammonium et le phosphate de tétrabutylammonium.

2. Composition de masque dur selon la revendication 1, dans laquelle le polymère d'organosilane est un produit de polycondensation d'hydrolysats représentés par les Formules 4, 5 et 6 :
[HO]₃Si-X (4)
dans laquelle X est un groupe fonctionnel en C₆-C₃₀ contenant au moins un noyau aromatique substitué ou non substitué ;
[HO]₃Si-R³ (5)
dans laquelle R³ est un groupe alkyle en C₁-C₁₂ ; et
[HO]₃Si-Y-Si[OH]₃ (6)
dans laquelle Y est un groupe de liaison choisi dans le groupe consistant en les noyaux aromatiques, les groupes alkylène en C₁-C₂₀ à chaîne droite ou ramifiée, substitués ou non substitués, les groupes alkylène en C₁-C₂₀ contenant dans le squelette un noyau aromatique, un noyau hétérocyclique, un groupe urée ou un groupe isocyanurate, et les groupes hydrocarbonés en C₂-C₂₀ contenant au moins une liaison multiple.

3. Composition de masque dur selon la revendication 2, dans laquelle le produit de polycondensation est un composé représentés par la Formule 7 :
{(SiO_{1,5}-Y-SiO_{1,5})ₓ(R³SiO_{1,5})_{y}(XSiO_{1,5})_{z}}ₙ (7)
dans laquelle x, y et z satisfont aux relations 0,05 = x, y = 0,9, 0 = z = 0,9 et x + y + z = 1 ; n vaut de 12 à 2000 ; X est un groupe fonctionnel en C₆-C₃₀ contenant au moins un noyau aromatique substitué ou non substitué ; R³ est un groupe alkyle en C₁-C₆ ; et Y est un groupe de liaison choisi dans le groupe consistant en les noyaux aromatiques, les groupes alkylène en C₁-C₂₀ à chaîne droite ou ramifiée, substitués ou non substitués, les groupes alkylène en C₁-C₂₀ contenant dans le squelette un noyau aromatique, un noyau hétérocyclique, un groupe urée ou un groupe isocyanurate, et les groupes hydrocarbonés en C₂-C₂₀ contenant au moins une liaison multiple.

4. Composition de masque dur selon la revendication 1, dans laquelle le polymère d'organosilane est préparé par mélange de 0 à 90 parties en poids du composé de Formule 1, de 5 à 90 parties en poids du composé de Formule 2 et de 5 à 90 parties en poids du composé de Formule 3, pour 100 parties en poids des composés de Formules 1, 2 et 3, et par le fait de permettre au mélange de réagir dans 100 à 900 parties en poids d'un solvant de réaction en présence de 0,001 à 5 parties en poids du catalyseur acide.

5. Composition de masque dur selon la revendication 1, dans laquelle le catalyseur acide est choisi dans le groupe consistant en l'acide nitrique, l'acide sulfurique, l'acide chlorhydrique, l'acide p-toluènesulfonique monohydraté, le sulfate de diéthyle et les mélanges de ceux-ci.

6. Composition de masque dur selon la revendication 1, dans laquelle le polymère d'organosilane est présent en une quantité de 1 à 50 parties en poids pour 100 parties en poids de la composition de masque dur.

7. Composition de masque dur selon la revendication 1, comprenant en outre au moins un additif choisi parmi les agents de réticulation, les stabilisants radicalaires et les tensioactifs.

8. Procédé de production d'un dispositif de circuit intégré à semi-conducteur, le procédé comprenant les étapes de :
(a) fourniture d'une couche de matière sur un substrat ;
(b) formation d'une première couche de masque dur, composée d'un matériau organique sur la couche de matière ;
(c) application de la composition de masque dur selon la revendication 1 sur la première couche de masque dur pour former une deuxième couche de masque dur antiréfléchissante ;
(d) formation d'une couche d'imagerie sensible au rayonnement sur la deuxième couche de masque dur antiréfléchissante ;
(e) exposition selon un motif de la couche d'imagerie à un rayonnement pour former un modèle de régions exposées au rayonnement à l'intérieur de la couche d'imagerie ;
(f) élimination sélective de portions de la couche d'imagerie sensible au rayonnement et de la deuxième couche de masque dur antiréfléchissante, pour exposer des portions de la première couche de masque dur ;
(h) élimination sélective de portions de la deuxième couche de masque dur antiréfléchissante à motifs et de la première couche de masque dur pour exposer des portions de la couche de matière ; et
(h) gravure des portions exposées de la couche de matière pour créer des motifs sur la couche de matière.

9. Procédé selon la revendication 8, comprenant en outre, avant l'étape (d), l'étape de formation d'un revêtement antiréfléchissant additionnel sur la deuxième couche de masque dur antiréfléchissante.

10. Dispositif de circuit intégré à semi-conducteur, produit par le procédé selon la revendication 8.

11. Dispositif de circuit intégré à semi-conducteur produit par le procédé selon la revendication 9.
